# EUROPÄISCHE PATENTSCHRIFT

(11) **EP 1 526 645 B1**
(45) Veröffentlichungstag und Bekanntmachung des Hinweises auf die Patenterteilung: **23.11.2011**
(21) Anmeldenummer: 04104958.6
(22) Anmeldetag: 11.10.2004
(51) Int. Cl.: H03K 17/95

(54) **Induktiver Näherungsschalter mit Differenzspulenanordnung**
Inductive proximity switch with differential coils
Commutateur de proximité inductif avec enroulements différentiels

(30) Priorität: 20.10.2003 DE 10348599; 30.10.2003 DE 10350733
(43) Veröffentlichungstag der Anmeldung: 27.04.2005
(73) Patentinhaber: Werner Turck GmbH & Co. KG, D-58553 Halver (DE)
(72) Erfinder: Ehls, Stefan, 58095 Hagen (DE); Müller, Jens, 42477 Radevormwald (DE)
(74) Vertreter: Grundmann, Dirk

(56) Entgegenhaltungen:
- EP-A- 0 304 272
- DE-A1- 3 934 593
- DE-C1- 19 850 749
- JP-A- 61 086 647
- US-A1- 2002 070 729

## Beschreibung

Die Erfindung betrifft einen induktiven Nährungsschalter.

Ein Näherungsschalter ist aus der DE 19740 774 A1 vorbekannt. Dort wird ein induktiver Näherungsschalter mit zwei Sendespulen und zwei Empfangsspulen beschrieben, wobei die Empfangsspule und die Sendespulen jeweils parallel zueinander angeordnet sind. Die Funktionsweise des dort beschriebenen Näherungsschalters beruht auf der Beeinflussung beider Empfangsspulen durchdringenden elektromagnetischen Wechselfelder, die von einem Auslöser erzeugt werden.

Ein weiterer Näherungsschalter ist aus der DE 40 31 252 C1 vorbekannt.

Diese Schrift beschreibt verschiedene Näherungsschalter, bei dem eine Sendespule von einem Oszillator mit einem Wechselstrom beaufschlagt wird. Dicht neben der Sendespule befinden sich zwei voneinander geringfügig beabstandete Empfängerspulen, die in Reihe geschaltet sind jedoch mit gegensinniger Wicklung. Die Lage der Empfängerspulen ist so gewählt, dass bei nicht angenähertem Auslöser in den beiden Differenzspulen ein Summenstrom nahe Null induziert wird. Bei einem der Ausführungsbeispiele sind zwei Spulenpaare auf je einer Leiterplatte angeordnet, die durch Klappen in eine Parallellage gebracht sind.

Wird ein metallischer Auslöser nun der Sendespule angenähert, so werden in dem Auslöser Wirbelströme erzeugt. Diese Wirbelströme erzeugen ein Gegenfeld zum Erregerfeld. Dieses Gegenfeld besitzt in den beiden Empfängerspulen eine unterschiedliche Stärke. Es induziert somit in den beiden Empfängerspulen unterschiedlich große Spannungen. Das Differenzsignal dieser beiden Spannungen weicht von Null ab und kann verstärkt werden, um das Ausgangssignal zu bilden.

Die DE 100 39 610 betrifft einen Näherungsschalter mit Schwingkreis, bei dem zwei Wicklungen vorgesehen sind, die analog zu den zuvor beschriebenen Näherungsschaltern ebenfalls miteinander elektromagnetisch gekoppelt sind.

Die DE 198 50 749 befasst sich mit einem zwei Detektorspulen und einer Sendespule arbeitenden induktiven Näherungsschalter, bei dem die Spulen als Planarspulen ausgebildet sind und ebenfalls in dem vom induzierten Wirbelstromfeld erzeugten Feld liegen.

Die DE 100 57 773 offenbart einen Näherungsschalter, bei dem eine Vielzahl von Spulen als Planarspulen nebeneinanderliegend einer Leiterplatte zugeordnet sind.

Ausgehend von dem eingangs genannten Stand der Technik liegt der Erfindung die Aufgabe zugrunde, Maßnahmen zu ergreifen, die den Schaltabstand erhöhen.

Gelöst wird die Aufgabe durch die in den Ansprüchen angegebene Erfindung.

Der Anspruch 1 betrifft einen induktiven Näherungsschalter mit einem eine Sendespule und eine erste Spule einer Empfangsspulenanordnung aufweisenden Sendespulenpaar, wobei die Sendespule ein Erregerfeld sendet, zum Induzieren von Wirbelströmen in einem in die Nähe des Näherungsschalters gebrachten metallischen Auslöser, welche Wirbelströme ein in der ersten Spule der Empfangsspulenanordnung eine Spannung induzierendes Wirbelstromfeld erzeugen, wobei die Spulen der Empfangsspulenanordnung so angeordnet und geschaltet sind, dass das Erregerfeld dort eine Differenzspannung erzeugt, und mit einem eine zweite Spule der Empfangsspulenanordnung und eine mit der Sendespule in Reihe geschalteten Kompensationsspule aufweisenden Kompensationsspulenpaar, wobei das Kompensationsspulenpaar vom Wirbelstromfeld nahezu unbeeinflussbar angeordnet ist.

Erfindungsgemäß ist somit vorgesehen, dass die zweite Spule der Empfangsspulenanordnung zusammen mit der Kompensationsspule vom Wirbelstromfeld nahezu unbeeinflussbar angeordnet ist. Dies kann dadurch erfolgen, dass die Spulenpaare in einem Winkel, insbesondere einem rechten Winkel zueinander angeordnet ist. Es ist alternativ dazu möglich, das die Kompensationsspule aufweisende Spulenpaar entweder abzuschirmen oder räumlich vom anderen Spulenpaar entfernt anzuordnen. Bevorzugt ist vorgesehen, dass die zweite Spule der Empfangsspulenanordnung und die Kompensationsspule koaxial zueinander dicht benachbart angeordnet sind.

Weiterbildungen der Erfindung, die auch eigenständigen Charakter haben, werden im Folgenden erörtert. Es ist vorgesehen, dass die zweite Spule der Empfangsspulenanordnung und die Kompensationsspule koaxial zueinander dicht benachbart angeordnet sind. Es kann vorgesehen sein, dass die Sendespule und die erste Spule der Empfangsspulenanordnung die selbe Wicklungsrichtung und die zweite Spule der Empfangsspulenanordnung und die Kompensationsspule eine entgegen gerichtete Wicklungsrichtung oder die Sendespule und die erste Spule der Empfangsspulenanordnung eine entgegengerichtete Wicklungsrichtung und die zweite Spule der Empfangsspulenanordnung und die Kompensationsspule die selbe Wicklungsrichtung haben. Außerdem kann vorgesehen sein, dass die Ebene die Sendespule bzw. der ersten Spule der Empfangsspulenanordnung unter einem Winkel größer Null, vorzugsweise 90° steht zur Ebene der zweiten Empfangsspulenanordnung bzw. der Kompensationsspule. In einer Weiterbildung ist vorgesehen, dass eines der beiden Spulenpaare, Sendespule und erste Spule der Empfangsspulenanordnung bzw. zweite Spule der Empfangsspulenanordnung und Kompensationsspule auf einer Leiterbahn als Planarspulen ausgebildet sind. Darüber hinaus ist vorgesehen, dass die beiden Spulen eines Spulenpaares auf den beiden sich gegenüberliegenden Seiten einer Leiterplatte angeordnet sind. Vorteilhaft ist es, wenn die die Kompensationsspule tragende Leiterplatte mit der Rückseite der die Sendespule tragenden Leiterplatte verbunden ist. Auch kann vorgesehen sein, dass die die Kompensationsspule tragende Leiterplatte der die Sendespule tragenden Leiterplatte diametral zugeordnet ist. Vorteilhaft ist es ferner, wenn das aus zwei Spulen der Empfangsspulenanordnung und die Kompensationsspule bestehende Spulenpaar entfernt oder abgeschirmt von dem aus der Sendespule und der ersten Spule der Empfangsspulenanordnung bestehenden Spulenpaar angeordnet ist. Eine Weiterbildung der Erfindung sieht vor, dass die Sendespule und die erste Spule der Empfangsspulenanordnung an einem mit einer festen Frequenz und Amplitude schwingenden Oszillator angeschlossen sind. Vorteilhaft ist es ferner, wenn die erste Spule der Empfangsspulenanordnung Teile eines Oszillators sind. Schließlich kann vorgesehen sein, dass die Sendespule und die erste Spule der Empfangsspule Teile eines selbstschwingenden, bei Annäherung des Auslösers bedämpften oder bei Annäherung des Auslösers anschwingenden Oszillators sind. Die Sendespule und die Kompensationsspule sind in Reihe geschaltet. Sie sind gleichsinnig gewickelt. Sie werden von einem Wechselspannungsgenerator gespeist. Die beiden Spulen der Empfangsspulenanordnung sind ebenfalls in Reihe geschaltet aber gegensinnig gewickelt. Die Spulen sind so aufeinander abgestimmt, dass bei entferntem Auslöser die Differenzspannung von der Empfangsspulenanordnung im Wesentlichen Null ist. Ein kleines Signal kann aber vorhanden sein. Wird nun ein Auslöser an die Sendespule angenähert, so wird in dem Metall des Auslösers ein Wirbelstrom induziert. Dieser Wirbelstrom erzeugt ein zum Erregerfeld gegengerichtetes Wirbelstromfeld. Da die zweite Spule der Empfangsspulenanordnung so angeordnet ist, dass sie vom Wirbelstromfeld nahezu unbeeinflußt bleibt, ist die Differenzspannung im Wesentlichen nur die Spannung, die vom Wirbelstromfeld in der ersten Spule der Empfangsspulenanordnung induziert wird. Dabei kann vorgesehen sein, dass diese Spannung dann einen Schwellwert erreicht, wenn der Abstand des Auslösers von der Sendespule dem Schaltabstand entspricht. Da zufolge der erfindungsgemäßen Lösung die Ausgangsspannung der Empfangsspulenanordnung nahezu gleich der Spannung ist, die in der ersten Empfangsspule von dem Wirbelstromfeld induziert wird, ist die Empfindlichkeit der gesamten Schaltung gegenüber der des Standes der Technik erhöht. Demzufolge sind höhere Schaltabstände möglich. Es ist aber auch möglich, dass die Ausgangsspannung der Empfangsspulenanordnung bei Erreichen des Schaltabstandes auf Null sinkt oder ihr Vorzeichen wechselt. Als vorteilhaft wird es angesehen, dass die Schaltung sehr temperaturstabil ist, da die beiden Spulenpaare jeweils einer Leiterplatte zugeordnet werden können. Die beiden Spulen jedes Spulenpaares können auf den voneinander wegweisenden Breitseiten der Leiterplatte mit den üblichen Beschichtungs-/ Ätzverfahren gefertigt werden. Die beiden Leiterplatten können mit einander verklebt werden. Hierzu wird die die Kompensationsspule tragende Leiterplatte mit ihrer Schmalseite insbesondere diametral auf die Rückseite der die Senderspule tragenden Leiterplatte aufgeklebt. Stehen die beiden Ebenen der Spulenpaare senkrecht zueinander, so können die beiden Spulenpaare in unmittelbarer Nachbarschaft angeordnet sein. Die Feldlinien des Wirbelstromfeldes durchdringen dabei im Wesentlichen nur die Wicklung der Sendespule bzw. der ersten Spule der Empfangsspulenanordnung. Die beiden anderen Spulen werden so gut wie nicht von den Feldlinien des Wirbelstromfeldes durchdrungen. In einer alternativen Ausgestaltung ist vorgesehen, dass das die Kompensationsspule aufweisende Spulenpaar entfernt von dem die Sendespule aufweisenden Spulenpaar angeordnet ist. Bei dieser Alternative wird allein durch die räumliche Distanzierung erreicht, dass die Kompensationsspule vom Wirbelstromfeld nahezu unbeeinflußt ist.

Diese Variante ist insbesondere bei Näherungsschaltern mit einem geringen Spulendurchmesser vorteilhaft. Beispielsweise ist es möglich, bei einem rohrförmigen Näherungsschalter, dessen Durchmesser zwischen 10 und 15 mm liegt, das Sendespulenpaar im vorderen Bereich des Sensors anzuordnen und das Kompensationsspulenpaar am anderen Ende des Rohres. Dabei sind die beiden Spulenpaare derart voneinander beabstandet, dass das Kompensationsspulenpaar praktisch nicht vom Wirbelstromfeld beeinflusst wird.

Alternativ dazu kann das die Kompensationsspule aufweisende Spulenpaar auch gegenüber dem Wirbelstromfeld durch geeignete Maßnahmen abgeschirmt werden.

Ausführungsbeispiele der Erfindung werden nachfolgend anhand beigefügter Zeichnungen erläutert. Es zeigen:
- Fig. 1: das Grundprinzip der erfindungsgemäßen Schaltung,
- Fig. 2: eine erste Anordnungsvariante der beiden Spulenpaare,
- Fig. 3: eine zweite Variante der Anordnung der beiden Spulenpaare,
- Fig. 4: eine weitere Variante der Anordnung der beiden Spulenpaare,
- Fig. 5: eine weitere Variante der Anordnung der beiden Spulenpaare,
- Fig. 6: ein Ausführungsbeispiel, bei dem die beiden Spulenpaare je auf einer Leiterplatte angeordnet sind und die beiden Leiterplatten miteinander verklebt sind in der Frontansicht,
- Fig. 7: eine Darstellung gemäß der Schnittlinie VII-VII in Fig. 6,
- Fig. 8: eine Ansicht in Richtung des Pfeiles VIII in Fig. 7,
- Fig. 9: ein erstes Schaltungsbeispiel und
- Fig. 10: ein zweites Schaltungsbeispiel.

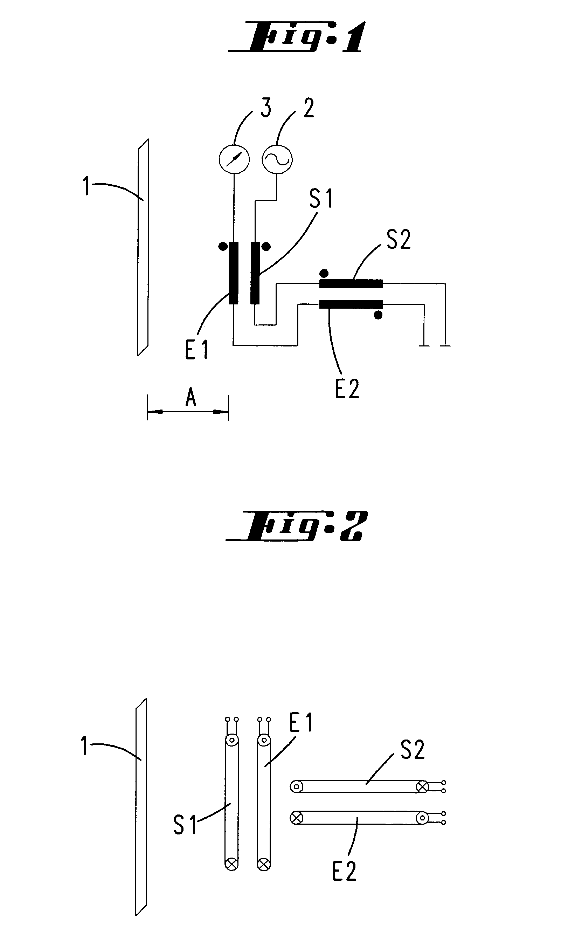

Das in der Fig. 1 dargestellte Grundprinzip zeigt die beiden Spulenpaare. Ein erstes Spulenpaar wird von der Sendespule S1 und der Empfängerspule E1 ausgebildet. Diese beiden Spulen sind koaxial zueinander angeordnet und haben einen gleichen Wicklungssinn. Funktionell distanziert von diesem ersten Spulenpaar ist ein zweites Spulenpaar vorgesehen, das aus der Kompensationsspule S2, die mit der Sendespule S1 in Reihe geschaltet ist, und der zweiten Spule E2 der Empfangsspulenanordnung besteht, die mit der ersten Spule E1 der Empfangsspulenanordnung in Reihe geschaltet ist. Die Kompensationsspule S2 und die zweite Spule E2 der Empfangsspulenanordnung liegen ebenfalls aufeinander und sind koaxial zueinander angeordnet, jedoch sind die beiden Spulen entgegengesetzt gewickelt. Die aus den beiden Spulen S1 und S2 bestehende Sendespulenanordnung ist mit einem Generator 2 verbunden. Dieser Generator 2 speist beide Spulen S1 und S2 mit einer Wechselspannung. Das von der Sendespule S1 ausgesandte Erregerfeld erzeugt in einem metallischen Auslöser 1, der der Sendespule S1 angenähert wird, Wirbelströme. Diese Wirbelströme erzeugen einen Gegenfeld zum Erregerfeld. Dieses Wirbelstromfeld überlagert sich in der Empfangsspule E1 mit dem von der Sendespule S1 erzeugten Erregerfeld. Zufolge der entgegengesetzten Richtungen der beiden Felder schwächt sich das effektive, in der Empfängerspule 1 vorhandene magnetische Feld ab. Dies hat zur Folge, dass in der Empfängerspule 1 eine etwas geringere Spannung induziert wird.

Von der zweiten Sendespule S2, die zuvor als Kompensationsspule bezeichnet worden ist, wird ein magnetisches Feld erzeugt. Dieses magnetische Feld induziert in der zweiten Empfängerspule E2 eine Spannung. Die beiden Empfängerspulen E1 und E2 sind so auf die beiden Sendespulen S1 und S2 abgestimmt, dass bei entfernt liegendem Auslöser 1 das Differenzausgangssignal gerade Null ist. Dies wird dadurch erreicht, dass bei einem der beiden Spulenpaare (beispielsweise S1, E1) die beiden Wicklungen den gleichen Wicklungssinn haben und bei dem anderen Spulenpaar, (beispielsweise S2, E2) die beiden Spulen entgegengerichtet gewickelt sind.

Das die Kompensationsspule S2 aufweisende Spulenpaar ist so angeordnet, dass es vom Wirbelstromfeld nahezu unbeeinflußt wird. Dies hat zur Folge, dass das Differenzausgangssignal 3 keinen reduzierenden Anteil wie beim Stand der Technik aufweist, sondern im Wesentlichen aus dem Induktionsanteil besteht, den das Wirbelstromfeld erzeugt.

Bei der in Fig. 2 dargestellten Ausführungsvariante sind die beiden Spulen S1 und E1 des ersten Spulenpaares nahezu gleichgroß ausgebildet. Auch die beiden Spulen des S2, E2 des zweiten Spulenpaares sind etwa gleich groß ausgebildet. Allerdings liegen die beiden Spulenpaare in zueinander senkrechten Ebene. Das die Sendespule S1 aufweisende Spulenpaar ist derart angeordnet, dass die Achse der Spule der Annäherungsachse des Auslösers 1 entspricht. Die Achse des zweiten Spulenpaares steht senkrecht auf dieser Achse.

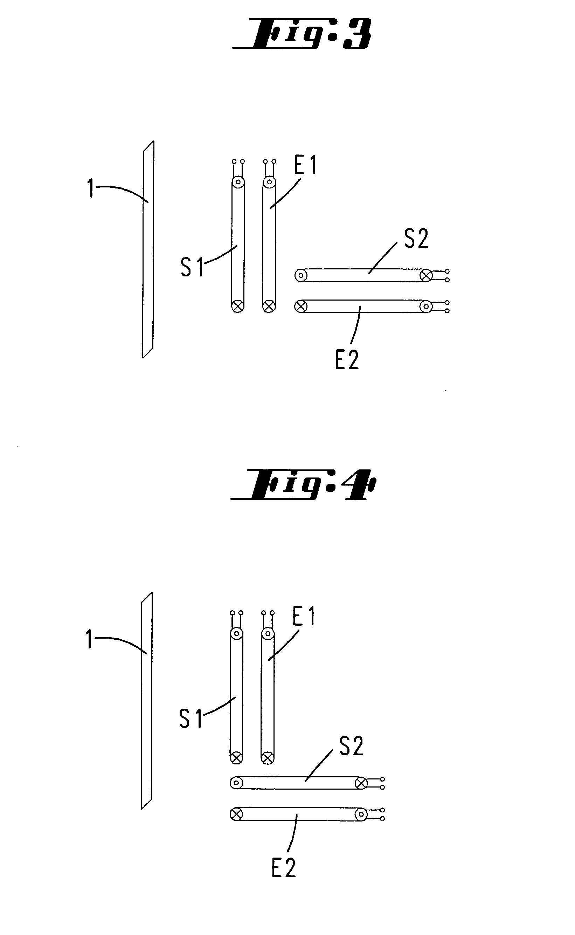

Auch bei den in den Figuren 3 und 4 dargestellten Ausführungsbeispielen steht die Achse des die Kompensationsspule S2 und die zweite Empfängerspule E2 aufweisenden Spulenpaares senkrecht zu der Achse des ersten Spulenpaares. Während bei dem in Fig. 2 dargestellten Ausführungsbeispiel die Mittelebene des die Kompensationsspule S2 aufweisenden Spulenpaares diametral zur Sendespule S1 angeordnet ist, ist bei dem in Fig. 3 dargestellten Ausführungsbeispiel die Mittelebene des die Kompensationsspule S2 aufweisenden Spulenpaares zum Rand hin versetzt. Bei dem in Fig. 4 dargestellten Ausführungsbeispiel ist die Mittelebene des die Kompensationsspule S2 aufweisenden Spulenpaares sogar nach außerhalb der Spulenfläche der Sendespule 1 versetzt.

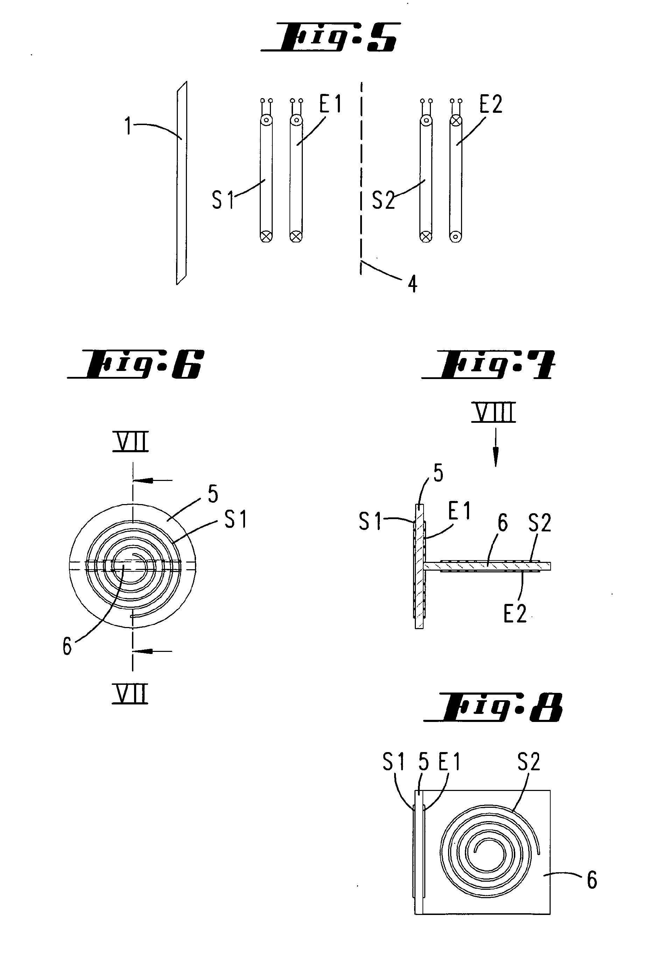

Bei dem in Fig. 5 dargestellten Ausführungsbeispiel sind die beiden Spulenpaare derart entfernt voneinander, dass das Wirbelstromfeld bei Erreichen des Schaltabstandes nur eine geringe Spannung in der Empfängerspule E2 induziert. Mit der Bezugsziffer 4 ist eine optionale Abschirmung zwischen den beiden Spulenpaaren bezeichnet. Mit dieser Abschirmung können die beiden Spulenpaare näher aneinander angeordnet werden. Anders als bei den in den Figuren 2, 3 und 4 dargestellten Ausführungsbeispiel liegen hier die Achsen der beiden Spulenpaare parallel zueinander.

Bei dem in Figuren 6 bis 8 dargestellten Ausführungsbeispiel sind die beiden Sendespulen S1 und S2 und die beiden Empfängerspulen E1 und E2 jeweils als Planarspulen auf einer Leiterbahn 5, 6 ausgebildet. Die Sendespule S1 liegt dabei auf der einen Seite der Leiterplatte 5. Die Empfängerspule E1 liegt auf der Rückseite derselben Leiterplatte 5. Beide Spulen haben eine Spiralform und werden aus einer durchgängigen Kupferbeschichtung herausgeätzt. In einer nicht dargestellten Variante befinden sich Sendespule S1 und Empfangsspule E1 auf derselben Seite der Leiterplatte.

Auch die Kompensationsspule S2 und die Empfängerspule E2 sind einer gemeinsamen Leiterplatte 6 zugeordnet. Im Ausführungsbeispiel liegen die beiden Spulen S2, E2 auf den beiden voneinander wegweisenden Breitseiten der Leiterplatte 6. Auch hier ist es möglich, die beiden Spulen S2, E2 auf der gleichen Leiterplattenseite anzuordnen. Die beiden Leiterplatten sind miteinander verklebt. Dabei ist die Schmalseite der Leiterplatte 6 diametral auf die Breitseite der Leiterplatte 5 aufgeklebt.

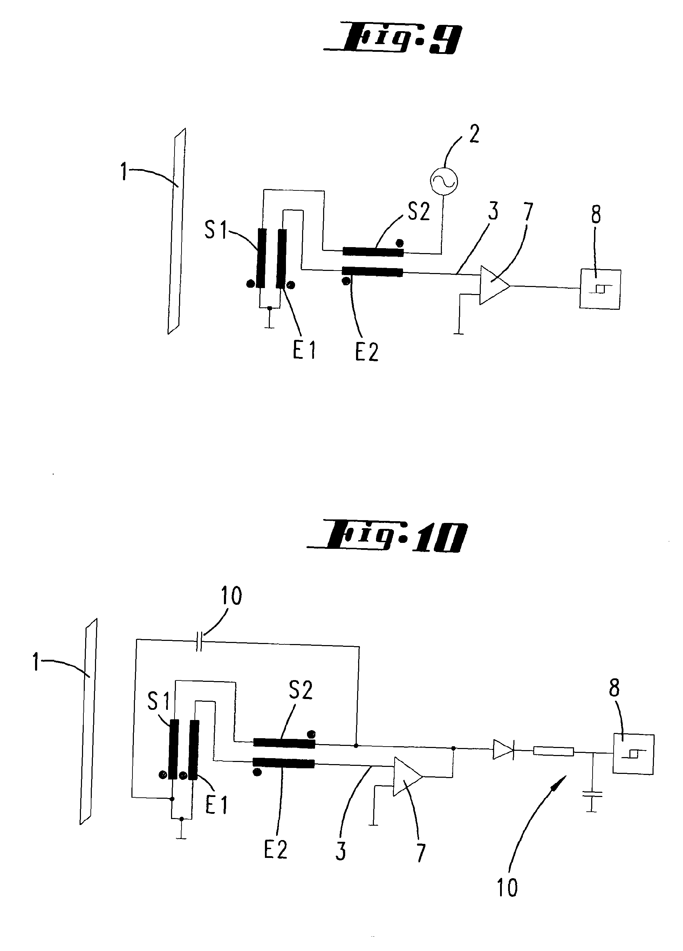

Die Fig. 9 zeigt ein erstes Schaltungsbeispiel. Hier sind die beiden Spulen S1 und S2 mit entgegengesetztem Wicklungssinn angeordnet. Die Spule S1 ist mit der Spule S2 in Reihe geschaltet. Beide Spulen S1 und S2 werden von einem Wechselspannungsgenerator 2 gespeist, so dass die Sendespule S1 ein magnetisches Wechselfeld erzeugt, welches in der Lage ist, in einem Blechauslöser 1 Wirbelströme zu erzeugen. Die auf der gleichen Leiterplatte mit der Kompensationsspule S2 angeordnete zweite Empfängerspule E2 ist mit der ersten Empfängerspule E1 in Reihe geschaltet und beide sind gleichsinnig gewickelt. Das Differenzausgangssignal dieser Empfangsspulenanordnung E1, E2 wird einem Verstärker zugeführt. Das Ausgangssignal wird in bekannter Weise einem Grenzwertschalter 8 zugeleitet. Dort wird in bekannter Weise (siehe DE 40 31 252 C1) das Schaltsignal erzeugt. Die Differenzspannung 3 ist im Wesentlichen proportional zu der in der Empfängerspule E1 von dem Wirbelstromfeld erzeugten Spannung.

Bei dem in Fig. 10 dargestellten Ausführungsbeispiel bilden die beiden Sendespulen S1 und S2 mit einem Kondensator 10 einen Schwingkreis. Dieser wird durch das Ausgangssignal eines Verstärkers 7 angeregt. Das Eingangssignal des Verstärkers ist das Differenzspannungssignal an Punkt 3 der beiden Empfängerspulen E1 und E2. Das Ausgangssignal des Verstärkers wird nicht nur in den Oszillator zurückgeführt, sondern gelangt über einen Tiefpass 10 an einen Grenzwertschalter, der in bekannter Weise das Ausgangssignal liefert. Die in Fig. 10 dargestellte Schaltung kann so eingestellt sein, dass das System so eben schwingt, wenn der Auslöser 1 weit entfernt ist. Bei Annäherung des Auslösers wird das Sendefeld derart geschwächt, dass die Schwingung abreißt. Es ist auch die umgekehrte Funktionsweise möglich. In der Ausgangsposition, bei entferntem Auslöser schwingt das System nicht. Erst wenn der Auslöser der Sendespule S1 angenähert wird, beginnt es zu schwingen.

Die Spulenanordnung ist nicht nur auf die zuvor beschriebenen Ausführungsbeispiele beschränkt. Es ist vielmehr auch vorgesehen und entspricht dem Gegenstand der Erfindung, dass die einzelnen Spulen S1, E1, S2 und E2 auch von Mehrfachspulenkomplexen ausgebildet sind, wie sie beispielsweise die DE 10057773 A1 beschreibt. Hinsichtlich der Ausgestaltung derartig verwendbarer Mehrfachspulen wird auch zum Zweck der Offenbarung auf die DE 10057773 verwiesen.

## Patentansprüche

1. Induktiver Näherungsschalter mit einer eine erste Spule (E1) und eine zweite Spule (E2) aufweisenden Empfangsspulenanordnung, wobei die erste Spule (E1) mit einer Sendespule (S1) ein Sendespulenpaar bildet, wobei die Sendespule (S1) ein Erregerfeld sendet, zum Induzieren von Wirbelströmen in einem in die Nähe des Näherungsschalters gebrachten metallischen Auslöser (1), welche Wirbelströme ein in der ersten Spule (E1) der Empfangsspulenanordnung eine Spannung induzierendes Wirbelstromfeld erzeugen, wobei die Spulen (E1, E2) der Empfangsspulenanordnung (E1, E2) so angeordnet und geschaltet sind, dass das Erregerfeld dort eine Differenzspannung (3) erzeugt, wobei die zweite Spule (E2) der Empfangsspulenanordnung mit einer mit der Sendespule (S1) in Reihe geschalteten Kompensationsspule (S2) ein Kompensationsspulenpaar ausbildet, welches vom Wirbelstromfeld nahezu unbeeinflussbar angeordnet ist, wobei entweder die Ebene des von der Sendespule (S1) und der ersten Spule (E1) der Empfangsspulenanordnung gebildeten Sendespulenpaares in einem Winkel größer null Grad, bevorzugt senkrecht zur Ebene des von der zweiten Spule (E2) der Empfangsspulenanordnung und der Kompensationsspule (S2) gebildeten Spulenpaares liegt, oder das Kompensationsspulenpaar (S2, E2) derartige räumliche Distanzierung zum Sendespulenpaar (S1, E1) besitzt oder eine Abschirmung besitzt, dass das Wirbelstromfeld im Bereich des Kompensationsspulenpaares erheblich geringer ist als im Bereich des Sendespulenpaares.

2. Induktiver Näherungsschalter nach Anspruch 1, **dadurch gekennzeichnet, dass** die Ebene der Sendespule (S1) bzw. der ersten Spule (E1) der Empfangsspulenanordnung in einem Winkel größer Null Grad, bevorzugt senkrecht zur Ebene der zweiten Spule (E2) der Empfangsspulenanordnung bzw. der Kompensationsspule (S2) liegt.

3. Näherungsschalter nach einem der vorherigen Ansprüche, **dadurch gekennzeichnet, dass** die zweite Spule (E2) der Empfangsspulenanordnung und die Kompensationsspule (S2) koaxial zueinander und dicht benachbart angeordnet sind. (E1, E2) sind ebenso angeordnet.

4. Näherungsschalter nach einem der vorherigen Ansprüche, **dadurch gekennzeichnet, dass** die erste Spule (E1) der Empfangsspulenanordnung und die Sendespule (s1) koaxial zueinander und dicht benachbart angeordnet sind.

5. Näherungsschalter nach einem der vorhergehenden Ansprüche, **dadurch gekennzeichnet, dass** die Sendespule (S1) und die erste Spule (E1) der Empfangsspulenanordnung dieselbe Wicklungsrichtung und die zweite Spule (E2) der Empfangsspulenanordnung und die Kompensationsspule (S2) eine entgegengerichtete Wicklungsrichtung oder die Sendespule (S2) und die erste Spule (E1) der Empfangsspulenanordnung eine entgegengerichtete Wicklungsrichtung und die zweite Spule (E2) der Empfangsspulenanordnung und die Kompensationsspule dieselbe Wicklungsrichtung haben.

6. Näherungsschalter nach einem der vorhergehenden Ansprüche, **dadurch gekennzeichnet, dass** eines der beiden Spulenpaare, Sendespule (S1) und erste Spule (E1) der Empfangsspulenanordnung bzw. zweite Spule (E2) der Empfangsspulenanordnung und Kompensationsspule (S2) auf einer Leiterplatte (5, 6) als Planarspulen ausgebildet sind.

7. Näherungsschalter nach einem der vorherigen Ansprüche, **dadurch gekennzeichnet, dass** die beiden Spulen je eines Spulenpaares auf den beiden sich
gegenüberliegenden Seiten einer Leiterplatte (5, 6) koaxial nebeneinander oder einander angeordnet sind.

8. Näherungsschalter nach einem der Ansprüche 6 oder 7, **dadurch gekennzeichnet, dass** die die Kompensationsspule (S2) tragende Leiterplatte (6) mit der Rückseite der die Sendespule (S1) tragenden Leiterplatte (5) verbunden ist.

9. Näherungsschalter nach einem der Ansprüche 6 bis 8, **dadurch** gekerulzeichnet, dass die die Kompensationsspule tragende Leiterplatte (6) der die Sendespule tragenden Leiterplatte (5) diametral zugeordnet ist.

10. Näherungsschalter nach einem der vorhergehenden Ansprüche, **dadurch gekennzeichnet, dass** die Sendespulen (S1, S2) einen mit einer festen Frequenz und Amplitude schwingenden Generator (2) angeschlossen sind.

11. Näherungsschalter nach einem der vorhergehenden Ansprüche 1 bis 9, **dadurch gekennzeichnet, dass** die Sendespulen (S1, S2) und die Empfangsspulen (E1, E2) eines selbstschwingenden, bei Annäherung des Auslösers bedämpften oder bei Annäherung des Auslösers anschwingenden Oszillator/Generator (2) sind.

## Claims

1. Inductive proximity switch with a receiving coil arrangement having a first coil (E1) and a second coil (E2), the first coil (E1) forming a transmitting coil pair with a transmitting coil (S1), the transmitting coil (S1) transmitting an excitation field, for inducing eddy currents in a metallic trip (1) brought into the vicinity of the proximity switch, which eddy currents generate a voltage-inducing eddy current field in the first coil (E1) of the receiving coil arrangement, the coils (E1, E2) of the receiving coil arrangement (E1, E2) being arranged and connected in such a way that the excitation field generates a differential voltage (3) therein, the second coil (E2) of the receiving coil arrangement forming a pair of compensating coils with a compensating coil (S2) connected in series with the transmitting coil (S1), which pair of compensating coils is virtually unable to be influenced by the eddy current field, either the plane of the pair of transmitting coils formed by the transmitting coil (S1) and the first coil (E1) of the receiving coil arrangement lying at an angle greater than zero degrees, preferably perpendicular, to the plane of the pair of coils formed by the second coil (E2) of the receiving coil arrangement and the compensating coil (S2), or the pair of compensating coils (S2, E2) having such spatial distancing from the pair of transmitting coils (S1, E1) or having a shielding, that the eddy current field in the region of the pair of compensatory coils is considerably smaller than in the region of the pair of transmitting coils.

2. Inductive proximity switch according to claim 1, **characterised in that** the plane of the transmitting coil (S1) or the first coil (E1) of the receiving coil arrangement lies at an angle greater than zero degrees, preferably perpendicular, to the plane of the second coil (E2) of the receiving coil arrangement or the compensating coil (S2).

3. Proximity switch according to any one of the preceding claims, **characterised in that** the second coil (E2) of the receiving coil arrangement and the compensating coil (S2) are arranged coaxially and closely adjacent to one another. (E1, E2) are arranged in the same way.

4. Proximity switch according to any one of the preceding claims, **characterised in that** the first coil (E1) of the receiving coil arrangement and the transmitting coil (s1) are arranged coaxially and closely adjacent to one another.

5. Proximity switch according to any one of the preceding claims, **characterised in that** the transmitting coil (S1) and the first coil (E1) of the receiving coil arrangement have the same winding direction, and the second coil (E2) of the receiving coil arrangement and the compensating coil (S2) have opposite winding directions, or the transmitting coil (S2) and the first coil (E1) of the receiving coil arrangement have opposite winding directions, and the second coil (E2) of the receiving coil arrangement and the compensating coil have the same winding direction.

6. Proximity switch according to any one of the preceding claims, **characterised in that** one of the two pairs of coils, the transmitting coil (S1) and the first coil (E1) of the receiving coil arrangement, or the second coil (E2) of the receiving coil arrangement and the compensating coil (S2), are formed as planar coils on a printed circuit board (5, 6).

7. Proximity switch according to any one of the preceding claims, **characterised in that** the two coils of each pair of coils are arranged on the two opposite sides of a printed circuit board (5, 6) coaxially next to one another or one another.

8. Proximity switch according to either claim 6 or claim 7, **characterised in that** the printed circuit board (6) carrying the compensating coil (S2) is connected to the rear side of the printed circuit board (5) carrying the transmitting coil (S1).

9. Proximity switch according to any one of claims 6 to 8, **characterised in that** the printed circuit board (6) carrying the compensating coil is diametrically associated with the printed circuit board (5) carrying the transmitting coil.

10. Proximity switch according to any one of the preceding claims, **characterised in that** the transmitting coils (S1, S2) are connected to a generator (2) oscillating with a fixed frequency and amplitude.

11. Proximity switch according to any one of claims 1 to 9, **characterised in that** the transmitting coils (S1, S2) and the receiving coils (E1, E2) are components of a self-oscillating oscillator/generator which is dampened when the trip approaches, or begins to oscillate which the trip approaches.

## Revendications

1. Détecteur de proximité inductif avec un agencement de bobines de réception présentant une première bobine (E1) et une deuxième bobine (E2), dans lequel la première bobine (E1) constitue avec une bobine d'émission (S1) une paire de bobines d'émission, dans lequel la bobine d'émission (S1) émet un champ d'excitation pour induire des courants de Foucault dans un déclencheur métallique (1) amené à proximité du détecteur de proximité, lesdits courants de Foucault produisant un champ de courant de Foucault induisant une tension dans la première bobine (E1) de l'agencement de bobines de réception, dans lequel les bobines (E1, E2) de l'agencement de bobines de réception (E1, E2) sont agencées et branchées de sorte que le champ d'excitation y produit une tension différentielle (3), dans lequel la deuxième bobine (E2) de l'agencement de bobines de réception constitue, avec une bobine de compensation (S2) branchée en série avec la bobine d'émission (S1), une paire de bobines de compensation, qui sont agencées de façon pratiquement non-influençable par le champ de courant de Foucault, dans lequel, soit le plan de la paire de bobines d'émission constituée par la bobine d'émission (S1) et la première bobine (E1) de l'agencement de bobines de réception est disposé à un angle supérieur à zéro degré, de préférence perpendiculairement, au plan de la paire de bobines constituée par la deuxième bobine (E2) de l'agencement de bobines de réception et la bobine de compensation (S2), ou la paire de bobines de compensation (S2, E2) présente une distance spatiale par rapport à la paire de bobines d'émission (S1, E1) ou est munie d'un blindage, tel que le champ de courant de Foucault dans la région de la paire de bobines de compensation est considérablement plus faible que dans la région de la paire de bobines d'émission.

2. Détecteur de proximité inductif selon la revendication 1, **caractérisé en ce que** le plan de la bobine d'émission (S1) ou, respectivement, la première bobine (E1) de l'agencement de bobines de réception est disposé selon un angle supérieur à zéro degrés, de préférence perpendiculairement au plan de la deuxième bobine (E2) de l'agencement de bobines de réception ou, respectivement, de la bobine de compensation (S2).

3. Détecteur de proximité selon l'une des revendications précédentes, **caractérisé en ce que** la deuxième bobine (E2) de l'agencement de bobines de réception et la bobine de compensation (S2) sont agencées coaxialement et étroitement adjacentes l'une à l'autre. (E1, E2) sont agencées de la même façon.

4. Détecteur de proximité selon l'une des revendications précédentes, **caractérisé en ce que** la première bobine (E1) de l'agencement de bobines de

5. Détecteur de proximité selon l'une des revendications précédentes, **caractérisé en ce que** la bobine d'émission (S1) et la première bobine (E1) de l'agencement de bobines de réception présentent le même sens d'enroulement et la deuxième bobine (E2) de l'agencement de bobines de réception et la bobine de compensation (S2) un sens d'enroulement opposé ou la bobine d'émission (S2) et la première bobine (E1) de l'agencement de bobines de réception présentent un sens d'enroulement opposé et la deuxième bobine (E2) de l'agencement de bobines de réception et la bobine de compensation le même sens d'enroulement.

6. Détecteur de proximité selon l'une des revendications précédentes, **caractérisé en ce que** l'une des deux paires de bobines, la bobine d'émission (S1) et la première bobine (E1) de l'agencement de bobines de réception ou, respectivement, la deuxième bobine (E2) de l'agencement de bobines de réception et la bobine de compensation (S2) sont réalisées sous forme de bobines planaires sur une plaque de circuit imprimé (5, 6).

7. Détecteur de proximité selon l'une des revendications précédentes, **caractérisé en ce que** les deux bobines de chaque paire de bobines sont disposées sur les deux faces opposées d'une plaque de circuit imprimé (5, 6) de façon coaxiale l'une à côté de l'autre ou l'une par rapport à l'autre.

8. Détecteur de proximité selon la revendication 6 ou 7, **caractérisé en ce que** la plaque de circuit imprimé (6) portant la bobine de compensation (S2) est reliée à la face arrière de la plaque de circuit imprimé (5) portant la bobine d'émission (S1).

9. Détecteur de proximité selon l'une des revendications 6 à 8, **caractérisé en ce que** la plaque de circuit imprimé (6) portant la bobine de compensation est associée de façon diamétrale avec la plaque de circuit imprimé (5) portant la bobine d'émission.

10. Détecteur de proximité selon l'une des revendications précédentes, **caractérisé en ce que** les bobines d'émission (S1, S2) sont raccordés à un générateur (2) oscillant avec une fréquence et une amplitude fixes.

11. Détecteur de proximité selon l'une des revendications précédentes 1 à 9, **caractérisé en ce que** les bobines d'émission (S1, S2) et les bobines de réception (E1, E2) constituent un oscillateur/générateur (2) qui est amorti lors de l'approche du déclencheur ou qui est amené en auto-oscillation lors de l'approche du déclencheur.
